# EUROPEAN PATENT SPECIFICATION

(11) **EP 1 693 900 B1**
(45) Date of publication and mention of the grant of the patent: **15.09.2010**
(21) Application number: 06000839.8
(22) Date of filing: 16.01.2006
(51) Int. Cl.: H01L 31/042, H01L 31/052

(54) **A solar cell array having a three dimension structure**
Solarzellenanordnung mit einer dreidimensionalen Struktur
Panneau solaire ayant une structure en trois dimensions

(30) Priority: 17.02.2005 JP 2005040828
(43) Date of publication of application: 23.08.2006
(73) Proprietor: Mitsunari, Shiro, Yamato-shi Kanagawa 242-0021 (JP)
(72) Inventor: Mitsunari, Shiro, Yamato-shi Kanagawa 242-0021 (JP)
(74) Representative: Manitz, Finsterwald & Partner GbR

(56) References cited:
- DE-A1- 4 141 083
- FR-A- 2 618 946
- US-A- 6 046 400
- PATENT ABSTRACTS OF JAPAN vol. 2003, no. 12, 5 December 2003 (2003-12-05) -& JP 2004 087743 A (SEKISUI JUSHI CO LTD), 18 March 2004 (2004-03-18)

## Description

### Technical Field

The present invention relates to a solar cell array improving a power generation amount per unit of setting area.

### Background Art

A photo voltaic system generating electric power by using a clean solar light energy has been known so far, and the photo voltaic system has been placed on a roof of a building or a roof of a house. A solar cell array includes a general photo voltaic system placed on an architectural structure and so on. The solar cell array is generally defined as an apparatus that plural pieces of a solar cell panel (module) combining plural solar cells are combined and set on a fixed board. As for the conventional solar cell array, the plural pieces of the solar cell panel are combined in a plane, thus an area of an acceptance surface of the solar cell array is nearly equal to an area where the solar cell array can be placed. However, a place where the solar cell array can placed is limited in the case of buildings, thus an increase of a power generation per unit of setting area is required as large as possible.

DE 4 141 083 describes a solar panel with reduced reflection losses.

### Summary of Invention

### Problems to be Resolved by Invention

It is an object of the present invention to provide a solar cell array increasing the power generation per unit of setting area, in view of drawbacks in the conventional technique described above.

### Means of Solving the Problems

Popular solar cell panels comprises serially wired plural solar cells embedded within a transparent filler and a front cover such as a glass etc. disposed on the surfaces of the solar cells in order to prevent damages etc. of the solar cell, thus a part of a solar light entering the solar cell panel is reflected on the surface of the front cover described, and an energy of a reflected light in an incident light energy cannot be used for a power generation so far. This loss of the incident light energy by the reflection on the surface of the front cover tends to increase as the incidence angle of the solar light becomes large, thus the reflection loss of the incident light energy in a time period when the sun altitude is low in the morning and in the evening becomes large.

In the meantime, the solar radiation reaching the ground surface includes the sky solar radiation which reaches the ground surface through multiple scattering and reflections in the aerospace as well as the direct sunlight which reaches the ground surface directly, and thus a part of the sky solar radiation also reaches a shadow area, and for example, it has been known that the accumulated amount of solar radiation per unit area on a flat surface extending perpendicular from a ground level while turning to the orientation of the true north and turning around on the sun is approximately one third of the amount of the solar radiation on the ground level.

The present invention is completed in view of the point described above, and also, the present invention is provided by considering to the fact that a three dimensional construction of the solar cell panel, which is conventionally configured in a plane, enables (1) the re-acceptance of the light reflected on the surface of one solar cell panel by another section of the solar cell panel and (2) the acceptance of the sky solar radiation in larger amount effectively by enlarging the area of the acceptance surface per unit of setting area so that the power generation amount per unit of setting area of the solar cell array may be increased totally.

According to the invention of claim 1 of the present application, a solar cell array having a three dimension multiple structure is provided, in which the solar cell array comprises a base acceptance surface including a solar cell, and plural vertical acceptance surfaces extending perpendicular from the base acceptance surface and comprising solar cells, wherein the plural vertical acceptance surfaces include solar cells on their both sides and are disposed parallel with each other.

According to the invention of claim 2 of the present application, the solar cell array of claim 1 is provided, wherein each of the vertical acceptance surfaces are formed by two solar cell panels adjacent to each other and output cables of the solar cell are placed in staggered positions so as to avoid overlap of the cables with each other.

According to the invention of claim 3 of the present invention, a solar cell array of is provided, wherein the plural vertical acceptance surfaces are placed on the base acceptance surface so as to provide a parallel crosses structure.

### Advantageous Effect of Invention

According to the present invention, the light, which is reflected on the surface of a front cover of the solar cell panel and that has not been contributed to power generation so far, may be provided for the power generation via. the incidence thereof to other solar cell panel to supply the reflected light for the power generation while making it possible to supply much sky solar radiation to the power generation, therefore, the power generation amount per unit setting area of the solar cell array is increased.

Besides, as for a particular embodiment of the present invention, in case of disposing the solar cell array on a mobile object such as an automobile etc., the power generation amount per unit setting area may be increased, even in case that a direction of a solar light seen from the mobile object is changed according to a movement of the mobile object.

### Brief Description of Drawings

Fig. 1 is a schematic perspective view of the solar cell array 1 disposed on the roof 20 of the house.
Fig. 2(a) is a perspective view of the solar cell array 1, and Fig. 2(b) is a cross-sectional view in case of cutting the solar cell array 1 along with the X-X line.
Fig. 3(a) depicts an embodiment in which the two vertical panels 2 are laminated together to face the respective backside surfaces thereof and Fig. 3(b) depicts an embodiment in which the vertical panels 14 and the vertical panel 15 are laminated together to face each of the backside surfaces.
Fig. 4 is a schematic perspective view showing an embodiment of attaching the plural vertical panels 2 on the base panel 5.
Fig. 5(a) depicts the acceptance surface of the vertical panels 2; Fig. 5(b) depicts the backside surface of the vertical panel 2; and Fig. 5(c) depicts a side view of the vertical panel 2.
Fig. 6 depicts an embodiment of the connection cables 11 and 12 connected to each vertical panel.
Fig. 7(a) is a perspective view of the solar cell array 13; Fig. 7 (b) is a cross-sectional view in case of cutting the solar cell array 13 along with the Y-Y line; and Fig. 7 (c) is a cross-sectional view in case of cutting the solar cell array 13 along with the Z-Z line.
Fig. 8 (a) depicts the backside surface of the vertical panel 14, and Fig. 8 (b) is a drawing showing the backside surface of the vertical panel 15.
Fig. 9 is a schematic perspective view showing an embodiment of disposing the vertical panel 14 and the vertical panel 15 on the base panel 5 in a double cross.
Fig. 10 depicts an embodiment of the connection cables 16, 17, 18, and 19 connected to each vertical panel.
Fig. 11 is a schematic drawing showing an embodiment of the solar light entering the solar cell array model 40.

### Description of Numerals

- 1.: solar cell array
- 2.: vertical panel
- 3.: connecter opening part
- 5.: base panel
- 6.: support
- 7.: terminal box
- 8.: output cable
- 9.: waterproof connecter
- 11.: connection cable
- 12.: connection cable
- 13.: solar cell array
- 14.: vertical panel
- 15.: vertical panel
- 16.: connection cable
- 17.: connection cable
- 18.: connection cable
- 19.: connection cable
- 20.: roof
- 30.: protection glass
- 40.: solar cell array model
- 40a.: base surface of solar cell array model
- 40b.: vertical surface of solar cell array model
- 40c.: vertical surface of solar cell array model

### Most Preferred Embodiment to Practice Invention

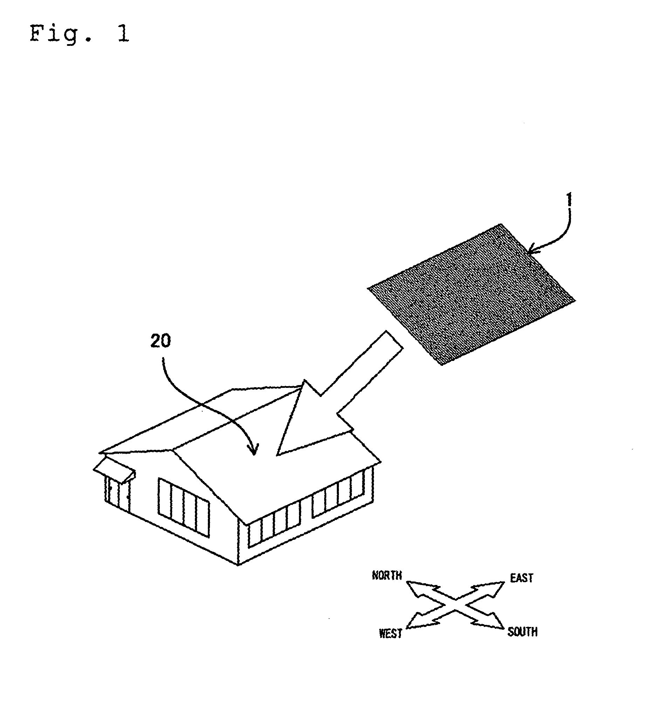

Now, preferred embodiments of the present invention will be described with referencing to drawings. Fig. 1 depicts a schematic view of the solar cell array 1 of the present invention disposed on the roof 20 of the house. In Fig. 1, the solar cell array 1 of the present invention is disposed such that a base acceptance surface faces due south on the roof of the house. Besides, as described in detail hereinafter, the solar cell array 1 of the present invention comprises vertical acceptance surfaces and the vertical acceptance surfaces are disposed so as to face an east-west direction. The solar cell array 1 receives the solar light from a south direction during daytime mainly with the base acceptance surface. The solar cell array 1 of the present invention generates the electric power in the morning and in the evening when an incidence angle of the solar light is large mainly by receiving the solar light with the vertical acceptance surfaces.

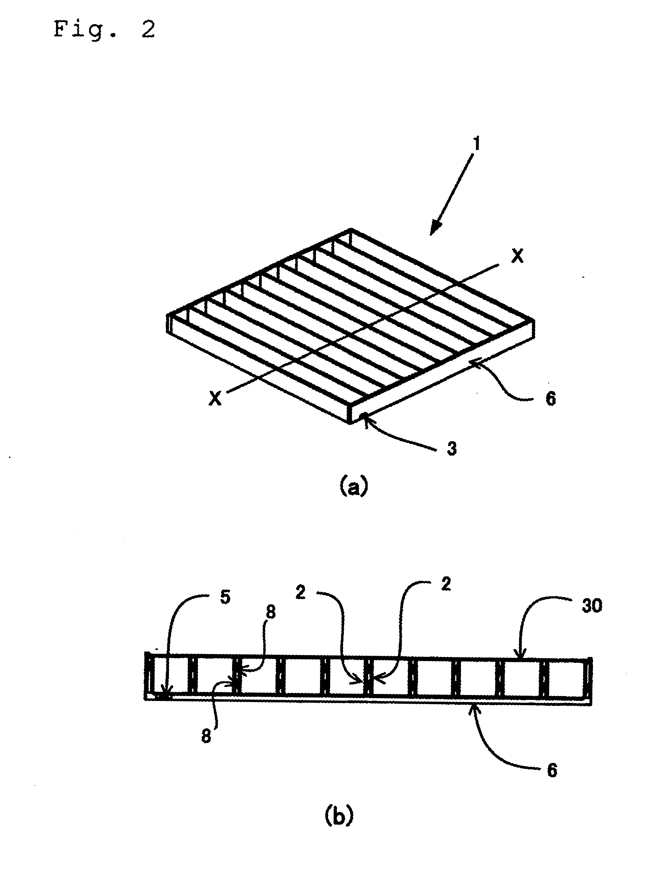

Fig. 2 shows a first embodiment of the solar cell array 1 of the present invention. The solar cell array 1 of the present invention is composed for the purpose that the solar cell array 1 is applied to a use for housing etc. where the base acceptance surface is used with an installation direction of the solar cell array 1 fixed to face almost south. Accordingly, solar cells are composed on the acceptance surface of the solar cell array 1; the acceptance surface of the solar cell array 1 of the present invention comprises the vertical acceptance surfaces, which the solar light from the east-west direction directly enters in the morning and in the evening and the base acceptance surface, which the solar light from the south direction directly enters by daytime. Fig. 2(a) is a perspective view of the solar cell array 1, and Fig. 2(b) is a cross-sectional view in case of cutting the solar cell array 1 along with the X-X line. The solar cell array 1 comprises the support 6, the protection glass 30, and the solar cell panel, and the solar cell panel includes one base panel 5 and plural vertical panels 2. As shown in Fig. 2, each of the vertical panels 2 extends perpendicular from the base panel 5, and they are also disposed parallel with each other at the same interval which are equal to a length of the vertical panels 2 in a height direction. Moreover, the protection glass 30 is disposed on the acceptance surface side of the support 6 to protect the acceptance surface from moisture, dust, etc. The vertical panels are formed by two solar cell panels with laminating the surfaces thereof not having solar cells facing each other. In addition, output cables 8 are disposed in staggered positions in the vertical panels so as to reduce thicknesses of each vertical panel formed by laminating two solar cell panels together.

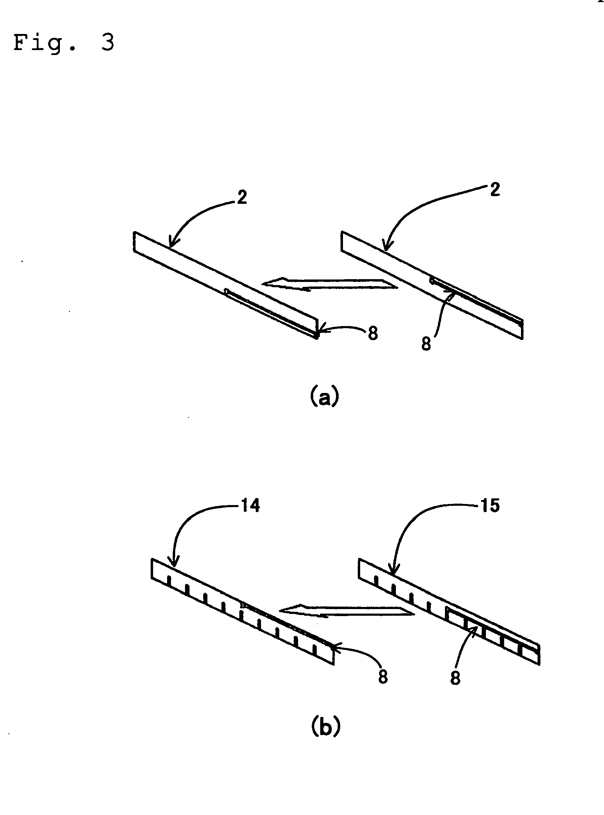

Fig. 3 (a) shows an embodiment in which the vertical panels comprise the acceptance surfaces on their both sides. As shown in Fig. 3(a), two vertical panels 2 are laminated together to face the respective backside surfaces thereof. Fig. 3 (b) shows an embodiment in which the vertical panels comprise the acceptance surfaces on the both sides thereof in a solar cell array construed to provide a parallel crosses structure described hereinafter. As shown in Fig. 3(b), two vertical panels 14 and 15 are laminated together to face each of the backside surfaces. Moreover, Fig. 3(b) shows an embodiment that the output cables 8 are disposed in staggered positions in the vertical panels to reduce the thickness of each vertical panel formed by adhering two vertical panels 14 and 15 together. The output cables 8 are furthermore disposed in positions so as not to across incisions which is prepared for arranging the double crosses of the panel.

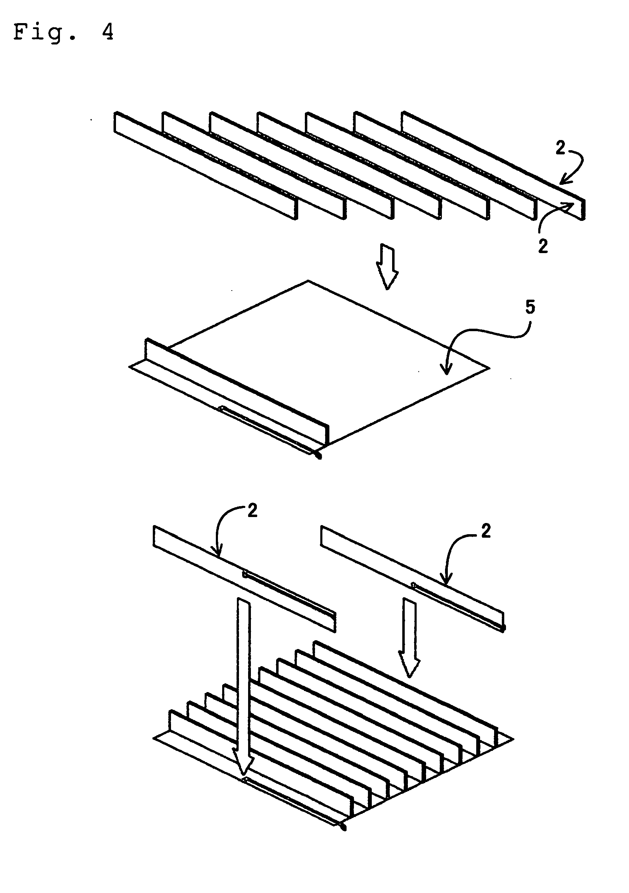

Fig. 4 illustrates an embodiment in case of attaching the plural vertical panels 2 on the base panel 5. As shown in Fig. 3 (a), two vertical panels 2 become one pair of vertical panels having the light acceptance surfaces on its both sides by adhering therebetween with facing each of the backside surfaces, and then the plural vertical panels described above are disposed such that the vertical panels extend perpendicular from the base panel 5 respectively. Moreover, the vertical panels 2 are disposed perpendicular from the base panel 5 with its light acceptance surface facing inside at both sides of the support 6. Moreover, each of the vertical panels is juxtaposed with each other and intervals having the length being equal to the height of the vertical panels. Besides, well-known adhesive materials can be appropriately used for forming the vertical panels extending perpendicularly from the base panel 5.

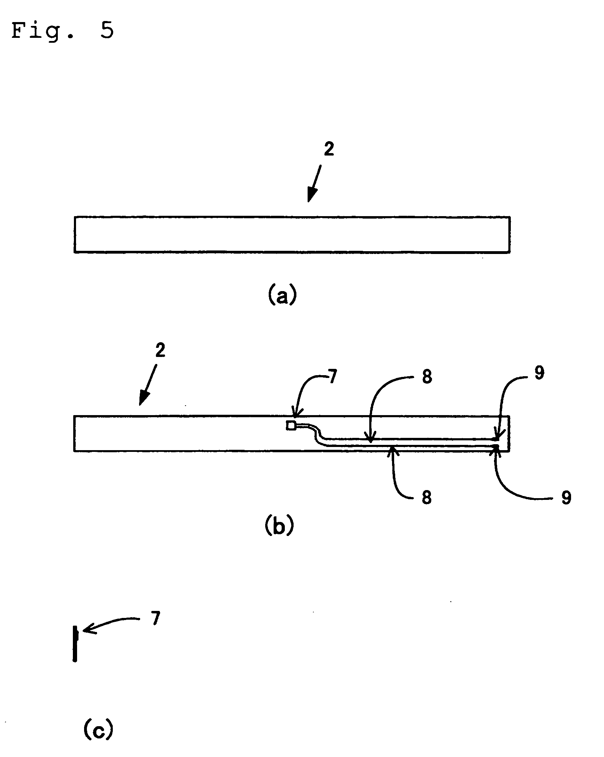

Fig. 5 shows a more detailed configuration of the vertical panels 2. Fig. 5(a) shows the acceptance surface on which the solar cells are composed in the vertical panels 2. The plural solar cells (not shown) are included in a clear filling agent on the acceptance surface side of the vertical panels 2, and on its surface, the front cover is disposed. However, the type of the solar cell included and the type of the front cover are not particularly limited in the present invention.
For example, as for the solar cell, well-known solar cells such as silicon series cells including single-crystalline silicon, polycrystalline silicon, amorphous silicon, etc., cells using compound materials except for silicon, etc. can be appropriately selected in accordance with a use environment. Moreover, also as for the front cover, well-known materials having a high light transmission and mechanical strength such as a white sheet reinforced glass, a translucent film, etc. can be appropriately selected in accordance with a use environment.

Fig. 5 (b) shows the backside surface of the vertical panel 2. The terminal box 7 is attached on the backside surface of the vertical panel 2, and the two output cables 8 are connected to the terminal box 7, and the waterproof connecter 9 is attached to the tip of each output cable 8. Fig. 5(c) is a side view of the vertical panel 2. As shown in Fig. 5(c), the terminal box 7 is attached to an upper part of the vertical panel in the height direction like a projection. Attaching the terminal box 7 to the upper part of the vertical panel in the height direction enables an attachment of each terminal box 7 in a staggered position in the case in which the two vertical panels 2 are adhered with facing each of the backside surfaces, as shown in Fig. 3(a).

An acceptance surface and a backside surface of the base panel 5 comprise the same structure as that of the vertical panel 2 described above. In the present embodiment, one solar cell panel is adopted to the base panel 5, however, in another embodiment, the plural solar cell panels can be configured in a plane.

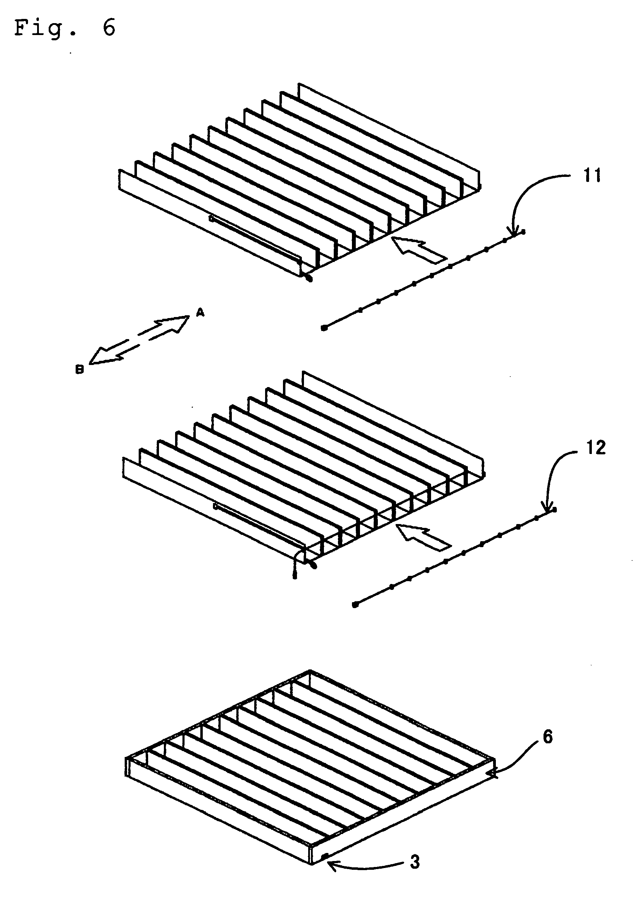

Fig. 6 shows an embodiment of a wiring of each solar cell panel. Here, it is assumed that the vertical panel 2 extending perpendicular with its acceptance surface facing toward the A direction of the arrow shown in Fig. 6 corresponds to a vertical panel 2A and that the vertical panel 2 extending perpendicular with its acceptance surface facing toward the B direction of the arrow shown in Fig. 6 corresponds to a vertical panel 2B, the amounts of light energy of the solar light entering the base panel 5, the vertical panel 2A, and the vertical panel 2B are different, respectively. A reason thereof is a slant angle of each panel to direct sunlight is different at one time, therefore, the amount of the direct sunlight which each panel receives is different from each other, and at the same time, the amount of the reflected light which each panel receives is also different from each other. Accordingly, an output amount of electricity in each panel is also different. Consequently, it is necessary to group each panel into the direction which the acceptance surface faces toward, install wires in each group described above, and then the panels are connected to an electric storage device through independent transformers disposed for each of the groups.

As shown in Fig. 6, the connection cable 11 is wired to each waterproof connecter 9 of the vertical panel 2A, and the connection cable 12 is wired to each waterproof connecter 9 of the vertical panel 2B. Each panel that the wire is installed in each group is attached to the support 6, and the respective connecters of the connection cable 11, the connection cable 12, and the output cable 8 of the base panel 5 are built up at a predetermined point and then are fixed into the connecter opening part 3 disposed in the support 6. Finally, the protection glass 30 is disposed on a not-shown acceptance surface side of the support 6.

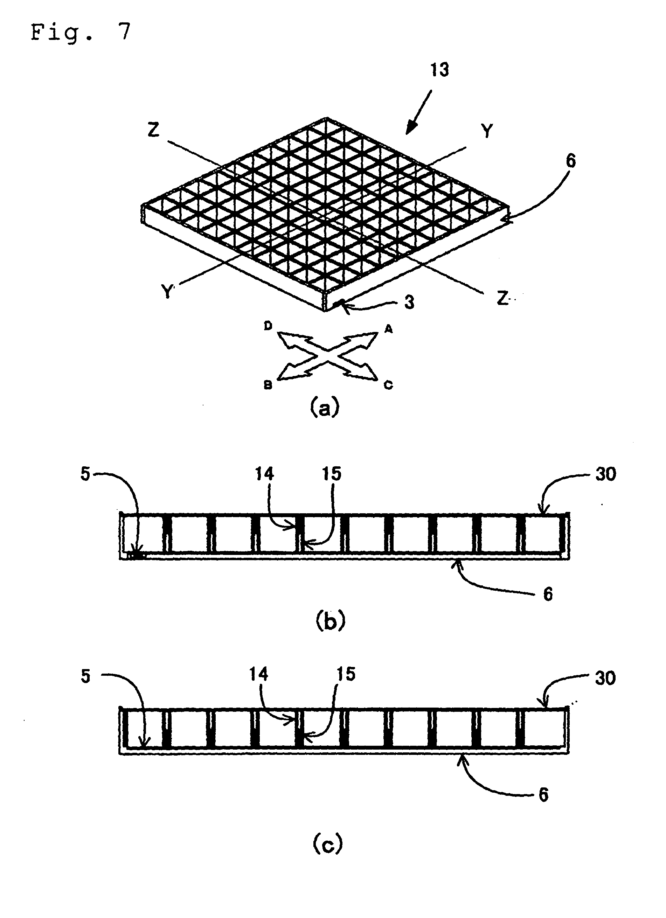

Fig. 7 shows the second embodiment of the solar cell array 13 of the present invention. The solar cell array 13 is composed for the purpose for disposing on a mobile object such as an automobile etc. In case of disposing the solar cell array 13 on the mobile object such as the automobile etc., an incidence direction of the solar light seen from the mobile object changes in accordance with the move of the mobile object. Accordingly, in the solar cell array 13, the acceptance surfaces of the vertical panels are composed to face toward the four directions of A, B, C, and D shown as the arrows so that they can receive the solar light entering from any direction effectively.

Fig. 7(a) is a perspective view of the solar cell array 13; Fig. 7 (b) is a cross-sectional view in case of cutting the solar cell array 13 along with the Y-Y line; and Fig. 7 (c) is a cross-sectional view in case of cutting the solar cell array 13 along with the Z-Z line. The solar cell array 13 comprises the solar cell panel, the support 6 and the protection glass 30. The solar cell panel described above includes one base panel 5, the plural vertical panels 14 and the vertical panel 15. Fig. 7(b) shows an embodiment that the vertical panels, each of which comprises the two vertical panels 14 and 15 shown in Fig. 3(b) described above and has the acceptance surfaces on its both sides, extending perpendicular from the base panel 5 with incisions thereof facing the side of the base panel 5. Moreover, in the same manner, Fig. 7(c) shows an embodiment that the vertical panels, each of which has the acceptance surfaces on its both sides, extending perpendicular from the base panel 5 with their incisions facing the side of the protection glass 30.

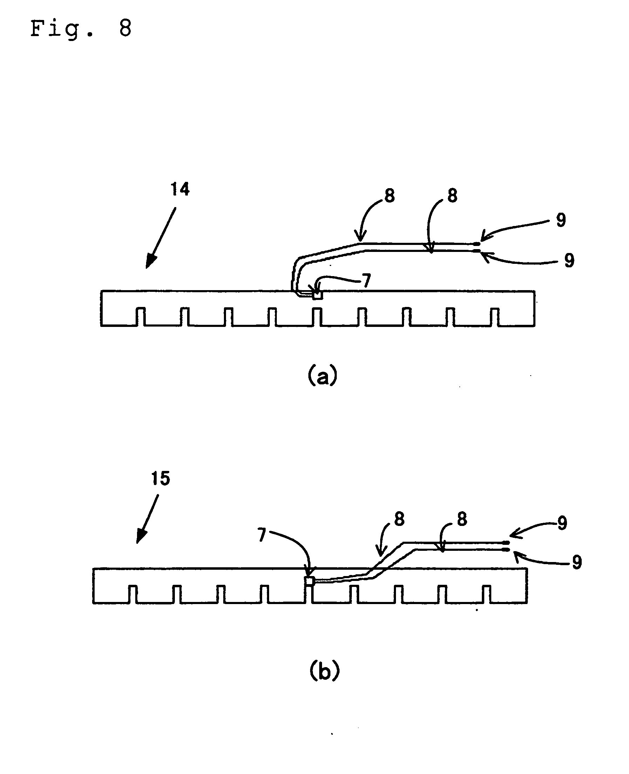

Fig. 8 (a) shows the backside surface of the vertical panel 14, and Fig. 8 (b) shows the backside surface of the vertical panel 15. In the vertical panel 14 and the vertical panel 15, the incisions shown in Fig. 7 (a) to compose the parallel cross structure are disposed. The terminal boxes 7 are distributed to the upper part and the lower part of the vertical panels so as to avoid overlap each other in the case in which the vertical panel 14 and the vertical panel 15 are adhered with facing each of the backside surfaces, as shown in Fig. 3(b). Moreover, the vertical panel 14 and the vertical panel 15 have acceptance surfaces on surfaces thereof (not shown) similar to that of the vertical panel 2, and the plural solar cells are included in transparent filler and on its surface, a front cover is disposed.

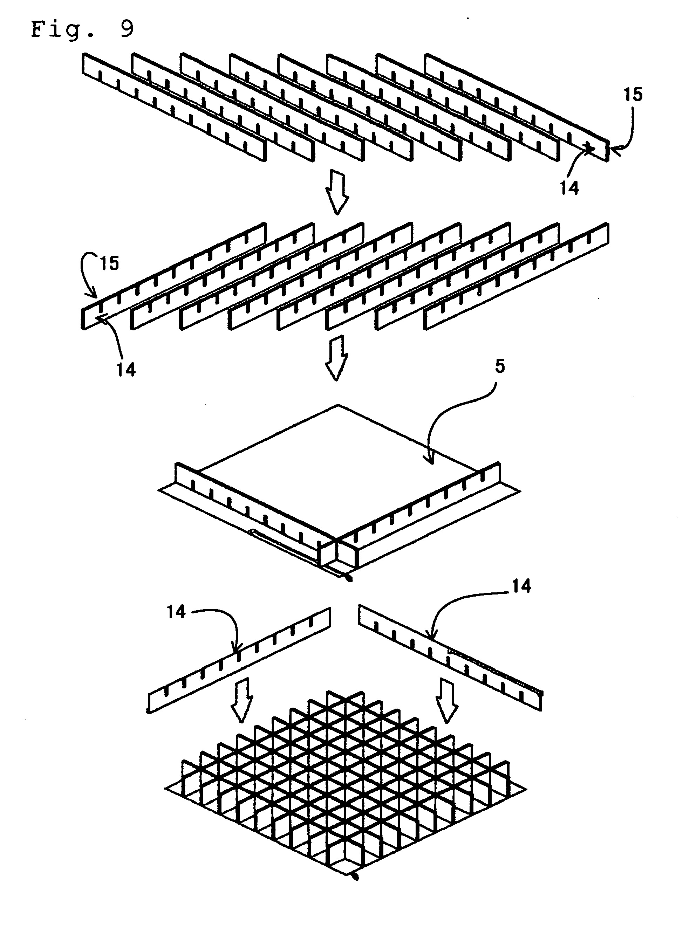

Fig. 9 illustrates an embodiment in case of attaching the plural vertical panels 14 and 15 on the base panel 5. As shown in Fig. 3(b), two (2) vertical panels 14, 15 become one pair of the vertical panel having the acceptance surfaces on its both sides resulting from an adhesion thereof with facing each of the backside surfaces. After that, one half of the plural vertical panels described above extends perpendicular from the base panel 5 with their incisions facing the side of the protection glass 30. Further, other one half of the plural vertical panels extends perpendicular from the base panel 5 with their incisions facing the side of the base panel 5 and crossing the incisions of the vertical panels built up previously. These steps provide a parallel crosses structure. Besides, well-known adhesive materials can be appropriately used for forming the vertical panels extending perpendicularly from the base panel 5.

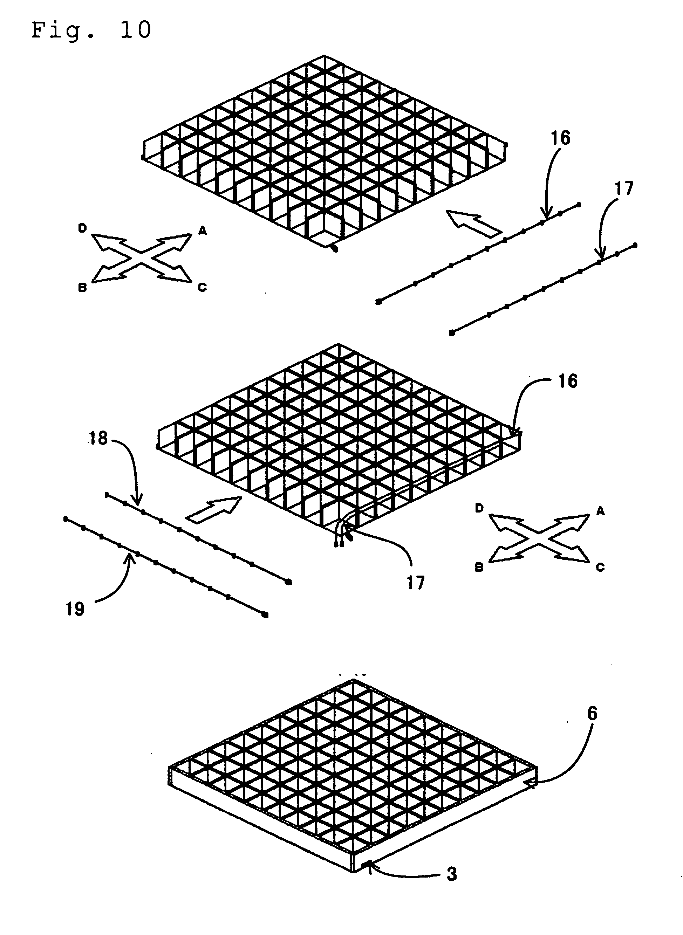

Fig. 10 shows an embodiment of a wiring of each solar cell panel. In the same manner as the first embodiment, each of the solar cell panels is grouped into the direction to which the acceptance surface faces; the vertical panel 14 having the acceptance surface in the direction of the arrow B shown in Fig. 10 is connected to the connection cable 16; the vertical panel 15 having the acceptance surface in the direction of the arrow A shown in Fig. 10 is connected to the connection cable 17; the vertical panel 15 having the acceptance surface in the direction of the arrow D shown in Fig. 10 is connected to the connection cable 18; and the vertical panel 14 having the acceptance surface in the direction of the arrow C shown in Fig. 10 is connected to the connection cable 19, respectively. Each panel to which the wire is connected in each group is attached to the support 6, and the connecters of the respective cables are built up at a predetermined point, and then, are fixed into the connecter opening part 3 disposed in the support 6. Finally, the protection glass 30 is disposed on an acceptance surface side of the support 6.

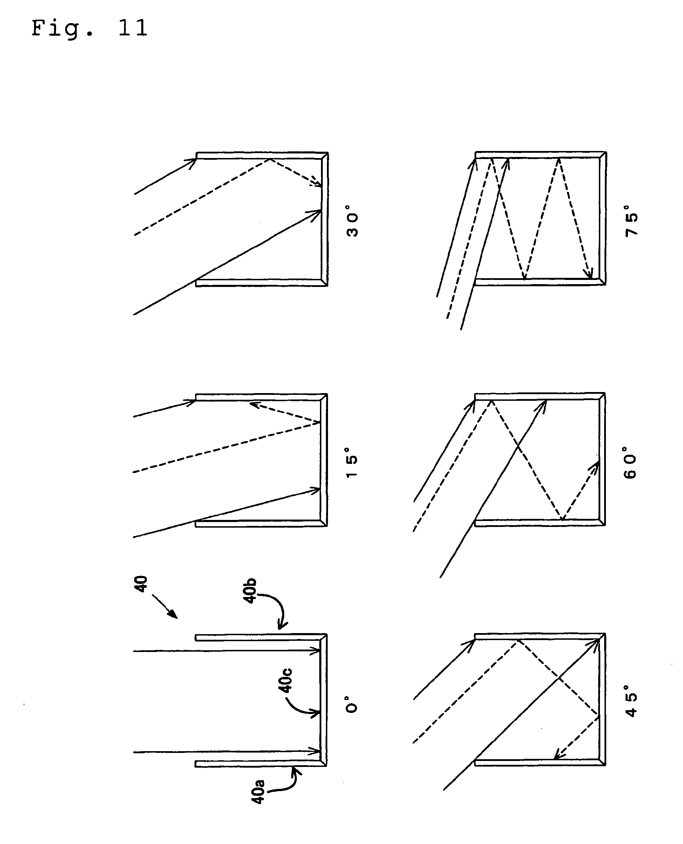

Fig. 11 schematically illustrates an embodiment of the solar light entering the solar cell array model 40 which is represented by the most simplified solar cell array according to the present invention at the incidence angle of 0 degree, 15 degrees, 30 degrees, 45 degrees, 60 degrees, and 75 degrees. The solar cell array model 40 comprises three acceptance surfaces of which lengths are equal each other in the height direction, and the two vertical surfaces 40a and 40b extend perpendicular from one base surface 40c. The conventional solar cell array having a plane structure merely indicates the base surface 40c when compared with the present model. Accordingly, it is recognized that the solar cell array model 40 has a triple area of acceptance surface per unit of setting area in comparison with the area of the conventional solar cell array having the plane structure. A part of the solar light entering each acceptance surface of the solar cell array model 40 is reflected, and the reflected light enters again the adjacent acceptance surface extending perpendicular from the acceptance surface, as described above, which the solar light has entered. The dashed lines in the respective solar cell array models 40 show a schematic embodiment of the reflection. Table 1 shows theoretical calculation values corresponding to the power generation amount per unit of setting area for each incidence angle. However, in this calculation, it is assumed that a direct reflection from the solar cell panel is 75%, a scattering light from the solar cell panel is 10%, and a conversion efficiency of the solar cell panel is 15%, and the scattering light from the solar cell panel and an outside is omitted.

**[Table 1]**

| Incidence Angle | Solar Cell Array Model 40/ Conventional Solar Cell Array |
|---|---|
| 75° | 3.466 |
| 60° | 2.734 |
| 45° | 2.315 |
| 30° | 1.866 |
| 15° | 1.433 |

embodiment, each vertical panel does not have to be connected to the base panel, and a gap for drainage and ventilation can also be disposed between each vertical panel and the base panel, for example. Moreover, in another embodiment, each panel does not necessarily be disposed in a box-shaped support, however, each panel can also be disposed in three dimensions by means of an engagement to stop to a support having a framework structure which comprises a gap for drainage and ventilation. Moreover, in another embodiment, a vertical panel having acceptance surfaces on its both sides can also be used. Furthermore, in another embodiment, a protection glass does not have to be disposed on an acceptance surface side for the purpose of a use in an environment free of an influence of moisture and dust, such as an outer space etc.

## Claims

1. A solar cell array having a three dimension multiple structure, and said solar cell array comprising:
a base acceptance surface including a solar cell, and
plural vertical acceptance surfaces extending perpendicular from said base acceptance surface and comprising solar cells,
wherein said plural vertical acceptance surfaces include solar cells on their both sides and are disposed parallel with each other.

2. The solar cell array of claim 1, wherein said vertical acceptance surfaces are formed by two solar cell panels adjacent to each other and output cables of said solar cells are placed in staggered positions so as to avoid overlap of said cables with each other.

3. The solar cell array of claim 1, wherein said plural vertical acceptance surfaces are placed on said base acceptance surface so as to provide a parallel cross structure.

## Patentansprüche

1. Solarzellenanordnung mit einer dreidimensionalen, multiplen Struktur, wobei die Solarzellenanordnung umfasst:
eine Basisakzeptanzfläche, die eine Solarzelle umfasst, und
mehrere vertikale Akzeptanzflächen, die sich senkrecht von der Basisakzeptanzfläche erstrecken und Solarzellen umfassen,
wobei die mehreren vertikalen Akzeptanzflächen Solarzellen auf ihren beiden Seiten umfassen und parallel zueinander angeordnet sind.

2. Solarzellenanordnung nach Anspruch 1,
wobei die vertikalen Akzeptanzflächen durch zwei Solarzellenpaneele gebildet sind, die benachbart zueinander liegen, und Ausgangskabel der Solarzellen in versetzten Positionen angeordnet sind, um eine gegenseitige Überlappung der Kabel zu vermeiden.

3. Solarzellenanordnung nach Anspruch 1,
wobei die mehreren vertikalen Akzeptanzflächen derart auf der Basisakzeptanzfläche angeordnet sind, dass eine parallele Kreuzstruktur vorgesehen ist.

## Revendications

1. Réseau de cellules solaires ayant une structure multiple à trois dimensions, ledit réseau de cellules solaires comprenant :
une surface d'acceptation de base incluant une cellule solaire, et
une pluralité de surfaces d'acceptation verticales s'étendant perpendiculairement depuis ladite surface d'acceptation de base et comprenant des cellules solaires,
dans lequel ladite pluralité de surfaces d'acceptation verticales incluent des cellules solaires sur leurs deux côtés et sont disposées parallèlement les unes aux autres.

2. Réseau de cellules solaires selon la revendication 1, dans lequel lesdites surfaces d'acceptation verticales sont formées par deux panneaux de cellules solaires adjacents l'un à l'autre, et des câbles de sortie desdites cellules solaires sont placés dans des positions en gradins de manière à éviter un chevauchement desdits câbles les uns avec les autres.

3. Réseau de cellules solaires selon la revendication 1, dans lequel ladite pluralité de surfaces d'acceptation verticales sont placées sur ladite surface d'acceptation de base de manière à constituer une structure à croix parallèles.
